# EUROPEAN PATENT APPLICATION

(11) **EP 4 683 490 A1**
(43) Date of publication of application: **21.01.2026**
(21) Application number: 25186519.2
(22) Date of filing: 01.07.2025
(51) Int. Cl.: H10W 70/68, H10W 74/01, H10W 74/10

(54) **CIRCUIT PACKAGE**

(30) Priority: 12.07.2024 US 202418771889
(71) Applicant: NXP USA, Inc., Austin, TX 78735 (US)
(72) Inventor: Au, Yin Kheng, 5656AG Eindhoven (NL); Chan, Mei Zhi, 5656AV Eindhoven (NL); Suhaimi, Ahmad Termizi, 5656AG Eindhoven (NL)
(74) Representative: Colaiuda, Antonella

(57) **Abstract**

One example discloses a circuit package, including: wherein the circuit package is configured to include a circuit; a brick having a first set of vias and a second set of vias; wherein the first set of vias are configured to be filled with a first material; wherein a first end of the first material is configured to be electrically coupled to the circuit; wherein a second end of the material is configured to form an electrical terminal on an external surface of the circuit package; and wherein the second set of vias are configured to be filled with a second material different from the first material.

## Description

The present specification relates to systems, methods, apparatuses, devices, articles of manufacture and instructions for circuit packages.

### SUMMARY

According to an example embodiment, a circuit package, comprising: wherein the circuit package is configured to include a circuit; a brick having a first set of vias and a second set of vias; wherein the first set of vias are configured to be filled with a first material; wherein a first end of the first material is configured to be electrically coupled to the circuit; wherein a second end of the material is configured to form an electrical terminal on an external surface of the circuit package; and wherein the second set of vias are configured to be filled with a second material different from the first material.

In another example embodiment, each of the first set of vias are surrounded by the second set of vias.

In another example embodiment, each of the second set of vias are surrounded by the first set of vias.

In another example embodiment, rows of the first set of vias alternate with rows of the second set of vias.

In another example embodiment, the brick is a dielectric material.

In another example embodiment, the first material is an electrically conductive material.

In another example embodiment, the second material is a molding compound.

In another example embodiment, the second material does not extend fully through a subset of the second set of vias.

In another example embodiment, further comprising a substrate coupled to the circuit and the brick; wherein the second set of vias are an exit path for a substance located at an interface between the substrate and the brick; and wherein the substance is pushed into the second set of vias by the molding compound during encapsulation.

In another example embodiment, the substance is at least one of: air, gas, liquid, flux, or solvent.

In another example embodiment, the interface is a solder attach area.

In another example embodiment, further comprising a solder paste configured to electrically couple the first end of the first material to an electrical trace in the circuit.

In another example embodiment, the circuit package has a top-side and a bottom-side; the top-side of the package is configured to be coupled to a heat sink; and the electrical terminal at the second end of the first material is exposed on the bottom-side of the package and configured to be electrically coupled to another circuit.

In another example embodiment, the another circuit is in a circuit board upon which the circuit package is mounted.

In another example embodiment, the vias are created by at least one of: a drill, ablation, etching, forming, or hole punching.

In another example embodiment, the vias start on a first-side of the brick, pass completely through the brick, and end at a second-side of the brick.

In another example embodiment, the vias start on a first-side of the brick and end at one or more locations inside the brick.

In another example embodiment, the brick includes a saw lane between a first set of rows and a second set of rows; the first set of rows in the brick are configured to be coupled to a first circuit within the circuit package and the second set of rows in the brick are configured to be coupled to a second circuit within the circuit package; and the saw lane is configured to physically separate the first circuit from the second circuit.

In another example embodiment, the circuit is an RF circuit.

According to an example embodiment, a method of fabricating a brick to be embedded in a circuit package, comprising: forming a first set of vias in the brick; filling the first set of vias with a first material; wherein a first end of the first material is configured to be electrically coupled to a circuit within the circuit package; wherein a second end of the material is configured to form an electrical terminal on an external surface of the circuit package; and forming a second set of vias in the brick; wherein the second set of vias are configured to be filled with a second material different from the first material.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example set of circuit packages before dicing.
Figures 2A, 2B represent a example views of a circuit package after dicing.
Figures 3A, 3B represent an example comparison before dicing of a first set of bricks having a first set of vias , and a second set of bricks having the first set of vias and a second set of vias.
Figures 4A, 4B represent an example comparison after dicing of the first example brick having the first set of vias, and the second example brick having the first set of vias and the second set of vias.
Figures 5A, 5B represent an example comparison of the first example brick having the first set of vias coupled to a first set of electrical traces on the substrate with a first set of solder paste, and the second example brick having the first set of vias and the second set of vias coupled to a second set of electrical traces on the substrate with a second set of solder paste.
Figures 6A, 6B represent an example comparison of the first example brick having the first set of vias encapsulated with the molding compound, and the second example brick having the first set of vias and the second set of vias encapsulated with the molding compound.
Figure 7 represents an example set of instructions for fabricating a brick to be embedded in a circuit package.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.

### DETAILED DESCRIPTION

Top-side cooled packages, as they can be called, provide better thermal performance in some applications. Due to the form factor of such packages, bricks (e.g. interposers) are used to electrically couple a set of top-side circuits, that are positioned closest to a heat-sink or other thermal management structure, to a bottom-side of the package that includes a set of I/O terminals for coupling to another device or circuit board.

Existing top-side cooled packages have a risk of molding compound voids forming underneath these bricks. The void are due to incomplete molding compound filling when air is trapped underneath the bricks as liquid molding compound encapsulated the top-side cooled package and imperfectly flows around the bricks.

Since the bricks are coupled to the top-side circuits with solder paste, these voids can permit solder to flow (i.e. create solder beads) between the brick's conductive traces that are used to electrically couple the brick's terminals to the top-side circuit's electrical contacts. During the solder paste reflow process, terminal to terminal shorting between the brick's conductive traces can occur resulting in a defective circuit package.

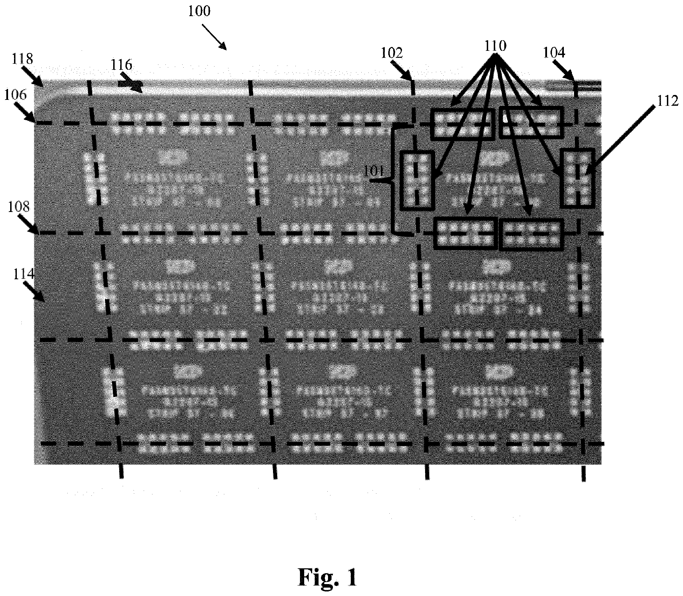

Figure 1 represents an example set of circuit packages 100 before dicing. The example set of circuit packages 100 includes one example circuit package 101 outlined by saw lanes 102, 104, 106, 108.

The example circuit package 101 includes a set of bricks 110 (e.g. interposers), each having a set of ten terminals 112 in this example embodiment. The bricks 110 are shared with neighboring circuit packages and are sawed in half during dicing.

A molding compound 114 (e.g. encapsulant) is contained by a barrier 116 and encapsulates the circuit packages 100 mounted on a laminate substrate 118. In various example embodiments, the circuit packages 100 include one or more of a set of circuits, a lead-frame, die-pad, a die/semiconductor chip, and/or a solder attach area, all of which are not explicitly shown in Figure 1. Electrical traces within and/or on the laminate substrate 118 electrically couple these various dies/chips and other circuit elements.

Arbitrarily, a first-side (e.g. top-side) of the circuit packages 100 is on the laminate substrate 118 side which can be mounted to a heat-sink for better cooling. A second-side (e.g. bottom-side) exposes the molding compound 114, the set of bricks 110 and the set of ten terminals 112. The bottom-side is configured to be mounted and electrically coupled to another device or circuit board (not shown) by the terminals 112.

These so called "top-side cooled packages" are often used in various high-powered RF products, such as for WiFi access point base stations.

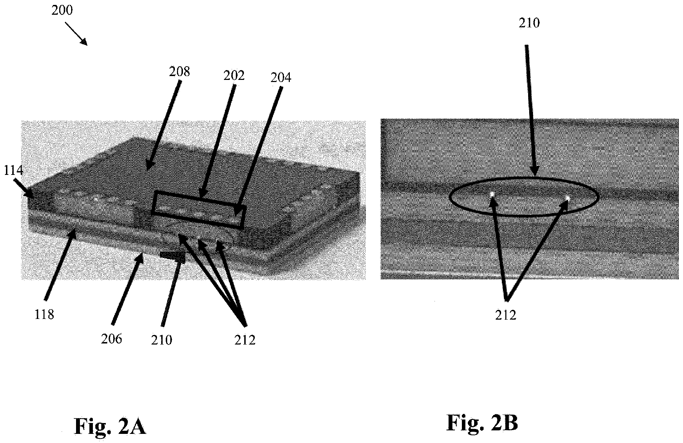

Figures 2A, 2B represent a example views 200 of the circuit package 101 after dicing.

In Figures 2A, the now diced example circuit package 101 includes a set of half-bricks 202 surrounding a perimeter of the example circuit package 101, each half-brick 202 having now only a set of five terminals 204. A first-side (e.g. top-side) 206 and a second-side (e.g. bottom-side) 208 are shown.

A solder attach area 210 between the bricks 202 and the top-side substrate 206 are shown. Due to voids (e.g. gaps, air bubbles, etc.) in the molding compound 114, a set of solder beads 212 form during reflow as the solder paste between electrical traces on the substrate 118 and the terminals 204 on the half-brick 202 migrates between several of the terminals 204.

Figures 2B shows a close-up of the solder attach area 210 and the solder beads 212 after dicing.

Now discussed is a perforated brick (e.g. perforated interposer) having additional vias (e.g. through holes, passages, etc.) for minimizing or eliminating molding compound voids, particularly where the brick interfaces with another surface (e.g. a lead-frame, a circuit board, a semiconductor chip, a substrate, a solder pad, etc.).

The additional set of vias provide a set of paths for trapped substances (e.g. air, gasses, liquids, flux, solvents, etc.) to be expelled (e.g. evacuated, pushed out) to prevent mold voids, particularly at the critical solder attach areas. In some example embodiments, the vias enable the gases to be pushed out toward a bottom-surface of the circuit package.

In various example embodiments, the additional vias are formed by drilling through the bricks during fabrication. However the additional vias can also be formed in other ways, such as by ablation, etching, brick forming, hole punching, etc.

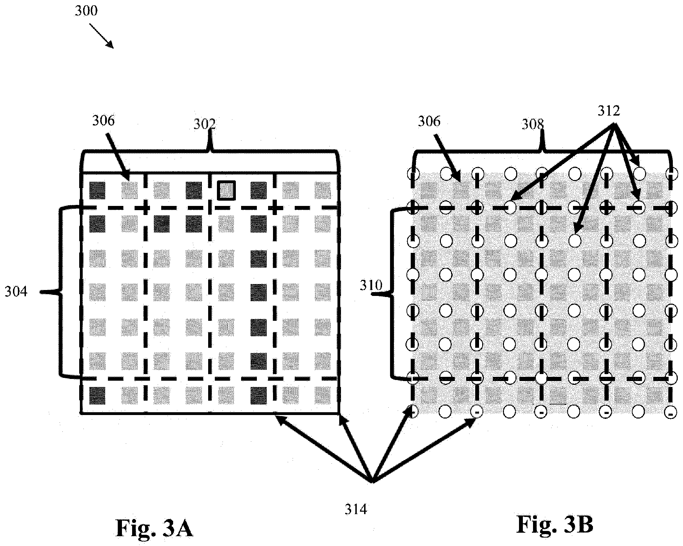

Figures 3A, 3B represent an example comparison 300 before dicing of a first set of bricks 302 having a first set of vias 306, and a second set of bricks 308 having the first set of vias 306 and a second set of vias 312.

The first set of bricks 302 includes a first example brick 304, and the second set of bricks 308 includes a second example brick 310. Saw lanes 314 that dice the bricks 302, 308 are also shown.

In various example embodiments, these bricks 302, 308 are fabricated separately before being mounted on the laminate substrate 118.

The bricks 302, 308 can be fabricated starting with a thick organic board (e.g. a multi layer PCB) into which a first set of holes are drilled to create the first set of vias 306. The first set of vias 306 are then filled with a first material (e.g. an electrically conductive material) to create a set of electrical paths between a first end of the bricks 304, 310 and a second end of the bricks 304, 310. The set of electrical paths are designed to eventually electrically couple electrical traces on the laminate substrate 118 to another device and/or circuit board (not shown).

The thick organic board is then sawed along the saw lanes 314 to create individual bricks such as example bricks 304 and 310.

A second set of holes, however, are drilled into the second set of bricks 308 to create the second set of vias 312, as shown in Figure 3B. The second set of vias 312 are then completely or partially filled with a second material (e.g. a molding compound) later during fabrication. The second set of vias 312 create a set of exit paths between the first end of the second brick 310 and a second end of the second brick 310. As mentioned above, these exit paths allow trapped substances (e.g. air, gasses, liquids, flux, solvents, etc.) to be expelled (e.g. evacuated, pushed out) during the encapsulation process to prevent mold voids, particularly at the critical solder attach areas.

In alternate example embodiments, one or more of the second set of holes are only partially drilled into the second set of bricks 308, at one or more depths, to create the second set of vias 312. In these alternate example embodiments, gas compression in the second set of vias 312 may be sufficient to enable the second material (e.g. a molding compound) to flow around the terminals 112, 204 in the solder attach areas so as to move any voids into the second set of vias 312 and away from between electrical traces 506 on the substrate 118.

In other example embodiments, the second set of vias 312 may have other uses, such as to lighten the bricks, and/or increase or decrease attenuation of wireless signals transmitted from circuits on the laminate substrate 118.

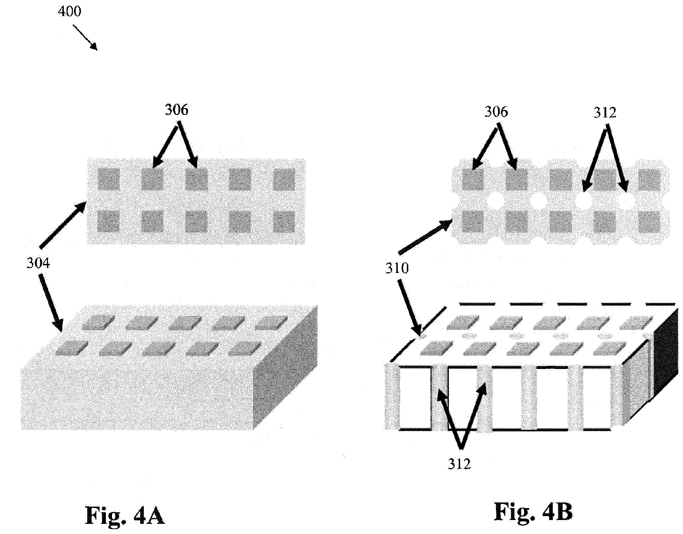

Figures 4A, 4B represent an example comparison 400 after dicing of the first example brick 304 having the first set of vias 306, and the second example brick 310 having the first set of vias 306 and the second set of vias 312.

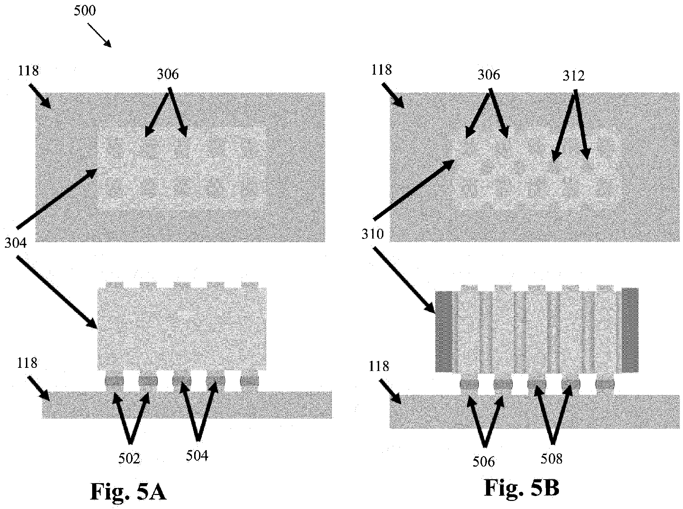

Figures 5A, 5B represent an example comparison 500 of the first example brick 304 having the first set of vias 306 coupled to a first set of electrical traces 502 on the substrate 118 with a first set of solder paste 504, and the second example brick 310 having the first set of vias 306 and the second set of vias 312 coupled to a second set of electrical traces 506 on the substrate 118 with a second set of solder paste 508.

In the example comparison 500 the bricks 304, 310 are mounted to circuits on and/or in the laminate substrate 118 before later encapsulation, solder reflow, and dicing.

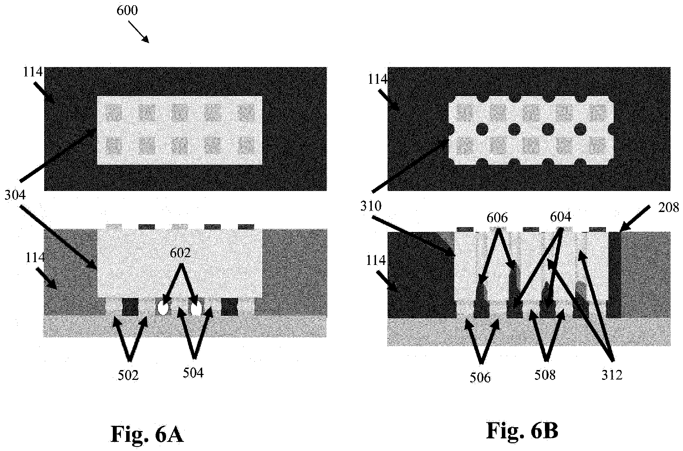

Figures 6A, 6B represent an example comparison 600 of the first example brick 304 having the first set of vias 306 encapsulated with the molding compound 114, and the second example brick 310 having the first set of vias 306 and the second set of vias 312 encapsulated with the molding compound 114.

The example comparison 600 shows that the first example brick 304 contains voids 602 between the first set of electrical traces 502 which will permit solder bead shorts to form after solder paste reflow.

The example comparison 600 shows that since the molding compound 114 during encapsulation can push substances away from the solder attach area, the second example brick 310 has no voids 604 between the second set of electrical traces 506 which will prevent solder bead shorts from forming after solder paste reflow.

The example comparison 600 also shows that the second set of vias 312 work so well that in some example embodiments the molding compound 114 can further extend either partially 606 or fully up through the second set of vias 312 to the other-side of the second example brick 310 (e.g. bottom-side 208 of the circuit package).

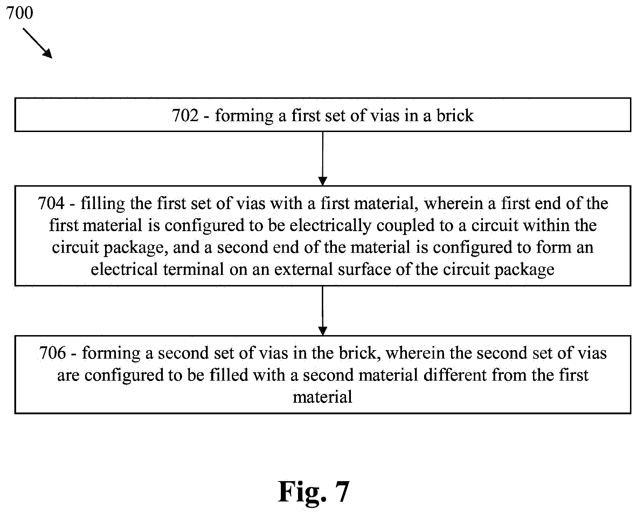

Figure 7 represents an example set of instructions 700 for fabricating a brick to be embedded in a circuit package.

An example instruction set in 702, forming a first set of vias in the brick. Next, in 704, filling the first set of vias with a first material, wherein a first end of the first material is configured to be electrically coupled to a circuit within the circuit package, and a second end of the material is configured to form an electrical terminal on an external surface of the circuit package. Then in 706, forming a second set of vias in the brick, wherein the second set of vias are configured to be filled with a second material different from the first material.

The instructions and/or flowchart steps in the above Figures can be executed in any order, unless a specific order is explicitly stated. Additionally, in some embodiments the instructions are implemented concurrently. Also, those skilled in the art will recognize that while one example set of instructions/method has been discussed, the material in this specification can be combined in a variety of ways to yield other examples as well, and are to be understood within a context provided by this detailed description.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A circuit package, comprising:
wherein the circuit package is configured to include a circuit;
a brick having a first set of vias and a second set of vias;
wherein the first set of vias are configured to be filled with a first material;
wherein a first end of the first material is configured to be electrically coupled to the circuit;
wherein a second end of the material is configured to form an electrical terminal on an external surface of the circuit package; and
wherein the second set of vias are configured to be filled with a second material different from the first material.

2. The package of claim 1:
wherein each of the first set of vias are surrounded by the second set of vias.

3. The package of claim 1:
wherein each of the second set of vias are surrounded by the first set of vias.

4. The package according to any preceding claim:
wherein rows of the first set of vias alternate with rows of the second set of vias.

5. The package according to any preceding claim:
wherein the brick is a dielectric material.

6. The package according to any preceding claim:
wherein the first material is an electrically conductive material.

7. The package according to any preceding claim:
wherein the second material is a molding compound.

8. The package according to any preceding claim:
wherein the second material does not extend fully through a subset of the second set of vias.

9. The package of claim 7:
further comprising a substrate coupled to the circuit and the brick;
wherein the second set of vias are an exit path for a substance located at an interface between the substrate and the brick; and
wherein the substance is pushed into the second set of vias by the molding compound during encapsulation.

10. The package according to any preceding claim:
further comprising a solder paste configured to electrically couple the first end of the first material to an electrical trace in the circuit.

11. The package of claim 10:
wherein the circuit package has a top-side and a bottom-side;
wherein the top-side of the package is configured to be coupled to a heat sink; and
wherein the electrical terminal at the second end of the first material is exposed on the bottom-side of the package and configured to be electrically coupled to another circuit.

12. The package according to any preceding claim:
wherein the vias start on a first-side of the brick, pass completely through the brick, and end at a second-side of the brick.

13. The package according to any preceding claim:
wherein the vias start on a first-side of the brick and end at one or more locations inside the brick.

14. The package according to any preceding claim:
wherein the brick includes a saw lane between a first set of rows and a second set of rows;
wherein the first set of rows in the brick are configured to be coupled to a first circuit within the circuit package and the second set of rows in the brick are configured to be coupled to a second circuit within the circuit package; and
wherein the saw lane is configured to physically separate the first circuit from the second circuit.

15. A method of fabricating a brick to be embedded in a circuit package, comprising:
forming a first set of vias in the brick;
filling the first set of vias with a first material;
wherein a first end of the first material is configured to be electrically coupled to a circuit within the circuit package;
wherein a second end of the material is configured to form an electrical terminal on an external surface of the circuit package; and
forming a second set of vias in the brick;
wherein the second set of vias are configured to be filled with a second material different from the first material.
